# EUROPEAN PATENT APPLICATION

(11) **EP 2 068 370 A1**
(43) Date of publication of application: **10.06.2009**
(21) Application number: 07807567.8
(22) Date of filing: 19.09.2007
(51) Int. Cl.: H01L 31/04, H01L 21/205

(54) **SOLAR CELL MODULE**

(30) Priority: 28.09.2006 JP 2006265868
(71) Applicant: Sanyo Electric Co., Ltd., Osaka 570-8677 (JP)
(72) Inventor: SHINOHARA, Wataru, . (JP)
(74) Representative: Calderbank, Thomas Roger
(86) International application number: PCT/JP2007/068198
(87) International publication number: WO 2008/038553

(57) **Abstract**

In a solar cell module, a photovoltaic layer and a bonding layer 15 are arranged in sequence on a transparent substrate 10. The photovoltaic layer is formed by multiple photovoltaic elements connected in series. Each photovoltaic element is formed by stacking in sequence a transparent conductive film 11, photoelectric conversion layers 12 and 13, and a back surface electrode 14. Furthermore, the solar cell module is provided with a first groove 22 configured to separate the photoelectric conversion layers 12 and 13 and the back surface electrode 14 on the transparent conductive film 11 at an end portion of the photovoltaic layer parallel to a series connection direction of the photovoltaic layer 1.

## Description

### TECHNICAL FIELD

The present invention relates to a solar cell module in which a photovoltaic layer and a bonding layer are disposed in sequence on a transparent substrate, the photovoltaic layer formed by connecting in series multiple photovoltaic elements each formed by stacking in sequence a first electrode, a photoelectric conversion layer, and a second electrode.

### BACKGROUND ART

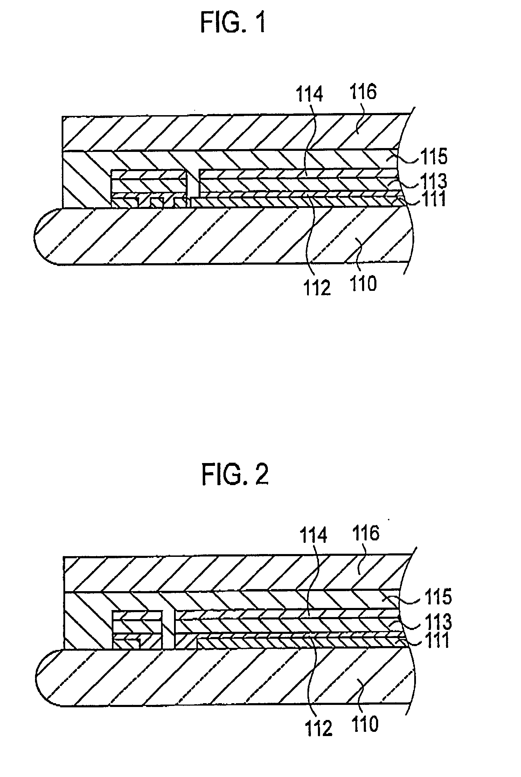

Recently, in order to simultaneously achieve low cost and high efficiency of a solar cell, a thin-film solar cell module requiring a small amount of raw material has been intensively developed. Figs. 1 and 2 each show one example of a cross-sectional view of such a thin-film solar cell module.

A photovoltaic element of a thin-film solar cell module is generally formed by stacking in sequence a first electrode 111, photoelectric conversion layers 112 and 113, and a second electrode 113 on an impermeable transparent substrate 110 formed of glass or the like, while patterning them by laser irradiation from the side of the substrate. In addition, the thin-film solar cell module is formed by bonding a protecting member 116 such as Poly Ethylene Terephtalate (PET) on the photovoltaic element with a bonding layer 115 such as Ethylene Vinyl Acetate (EVA) (refer to Japanese Patent Publication No. Showa 63-261883).

Here, the bonding layer 115 serves as an adhesive agent and a buffering agent between the protecting member 116 and the photovoltaic element. The protecting member 116 has a function of preventing moisture from penetrating from outside.

### DISCLOSURE OF THE INVENTION

However, since a solar cell module is used outdoors over a long period of time, moisture penetrates from end portions or the like of the solar cell module. In addition, internal stress of the photoelectric conversion layers 112 and 113 causes exfoliation on an interface between a surface of the transparent substrate 110 and the photoelectric conversion layer 112, thereby frequently causing exfoliation of the film.

Particularly, in the thin-film silicon solar cell module in which microcrystalline silicon (µc-Si:H) is used for the photoelectric conversion layers 112 and 113, internal stress of µc-Si:H is quite large compared with those of other electrode film and amorphous silicon (a-Si:H). If, having the smallest boding force, an interface between the transparent substrate 110 and the photoelectric conversion layer 112 exists at an end portion which is parallel to a series connection direction of the photovoltaic layer as shown in Figs. 1 and 2, the problem arises that remarkable exfoliation occurs on the interface.

In light of the above-described problems, an object of the present invention is to provide a thin-film solar cell module which suppresses exfoliation of a film.

A feature of the present invention provides a solar cell module in which a photovoltaic layer and a bonding layer are disposed in sequence on a transparent substrate, the photovoltaic layer formed by connecting in series a plurality of photovoltaic elements each formed by stacking in sequence a first electrode, a photoelectric conversion layer, and a second electrode. The solar cell module includes a groove configured to separate both of the photoelectric conversion layer and the second electrode on the first electrode at an end portion of the photovoltaic layer parallel to a series connection direction of the photovoltaic layer.

In accordance with the solar cell module according to the present invention, no interface exists between the transparent substrate and the photoelectric conversion layer. Thus, exfoliation of a film can be suppressed.

The solar cell module in accordance with the feature of the present invention may further include a stacked body formed by stacking in sequence the first electrode and the photoelectric conversion layer on the transparent substrate at an end portion of the bonding layer parallel to the series connection direction of the photovoltaic layer, and the stacked body is arranged to be electrically isolated from the photovoltaic layer.

In accordance with the solar cell module, by disposing the stacked body at the end portion of the bonding layer, moisture can be prevented from penetrating from the end portions through the bonding surface between the bonding layer and the transparent substrate.

Further, in the solar cell module described above, it is preferable that a width of a groove separating the photovoltaic layer and the stacked body be equal to or more than 0.1 mm.

In accordance with the solar cell module, the photovoltaic layer and the stacked body can be securely electrically isolated from each other.

Further, in the solar cell module described above, an insulating film may be embedded in the groove separating the photovoltaic layer and the stacked body.

In accordance with the solar cell module, by providing the insulating film, it is possible to enhance the insulating property and strength against destruction.

Still further, in the solar cell module described above, it is preferable that the insulating film be any one of materials of silicon oxide, silicon nitride, aluminum oxide, titanium oxide, and magnesium fluoride, or a resin material including particles of at least one of these materials.

In accordance with the present invention, it is possible to provide the thin-film solar cell module which is capable of suppressing exfoliation of a film.

### BRIEF DESCRIPTION OF THE DRAWINGS

[Fig. 1] Fig. 1 is a cross sectional view showing a configuration of a thin-film solar cell sub-module according to Conventional Example 1.
[Fig. 2] Fig. 2 is a cross-sectional view showing a configuration of a thin-film solar cell sub-module according to Conventional Example 2.
[Fig. 3] Fig. 3 is a top view showing a thin-film solar cell sub-module according to this embodiment.
[Fig. 4] Fig. 4 is a view showing an end portion of an A-A section of Fig. 1.
[Fig. 5] Fig. 5 is another view showing the end portion of the A-A section of Fig. 1.
[Fig. 6] Fig. 6 is a view showing an end portion of a B-B section of Fig. 1.
[Fig. 7] Fig. 7 is a schematic view (Part 1) showing a manufacturing method of the thin-film solar cell sub-module according to this embodiment.
[Fig. 8] Fig. 8 is a schematic view (Part 2) showing the manufacturing method of the thin-film solar cell sub-module according to this embodiment.
[Fig. 9] Fig. 9 is a graph showing exfoliation on an interface of a thin-film solar cell module according to a conventional example in a reliability test.

### BEST MODES FOR CARRYING OUT THE INVENTION

Next, an embodiment of the present invention will be described with reference to the drawings. In the descriptions of the drawings below, the same or similar portions are denoted by the same or similar reference numerals. However, it should be noted that the drawings are schematic, and proportions of sizes and the like therein are different from actual ones. Thus, specific sizes and the like should be determined in light of the following description. Needless to say, there are portions where relationships or proportions of sizes of the drawings are different from one another.

### (Solar Cell Module)

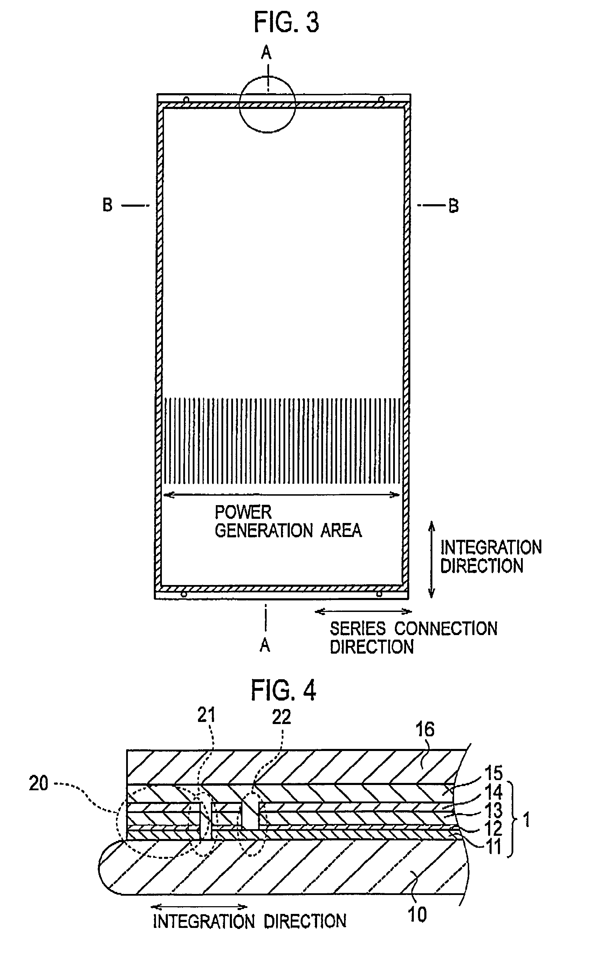

Fig. 3 shows a top view of a solar cell sub-module (a solar cell element) of a thin-film solar cell module according to this embodiment. The inside of a frame (an outline area) located at the center of the thin-film solar cell sub-module is a power generation area. Fig. 4 is an A-A cross-sectional view of Fig. 3, and is an enlarged view of an upper end surface (a portion surrounded by a circle in Fig. 3) of Fig. 3.

As shown in Fig. 4, in the thin-film solar cell sub-module according to this embodiment, on a transparent substrate 10, a photovoltaic layer 1 in which multiple photovoltaic elements are connected in series, a bonding layer 15, and a protecting member 16 are disposed in sequence. The multiple photovoltaic elements are each formed by stacking in sequence a transparent conductive film (a first electrode) 11, photoelectric conversion layers 12 and 13, and a back surface electrode (a second electrode) 14. In Fig. 4, the multiple photovoltaic elements, the bonding layer 15, and the protecting member 16 are disposed in sequence on the back surface side opposite to the light incident side of the transparent substrate 10.

The transparent substrate 10 is a single substrate of the solar cell sub-module. On the back surface side opposite to the light incident side of the transparent substrate 10, the multiple photovoltaic elements are formed. The transparent substrate 10 is composed of a light transmissive member such as glass.

When viewed in a planar manner, the transparent conductive film 11 (first electrode) is formed in strips on the transparent substrate 10. The transparent conductive film 11 consists of a single type or multiple types of stacked bodies selected from a group of metal oxides obtained by doping ZnO, In₂O₃, SnO₂, CdO, TiO₂, CdIn₂O₄, Cd₂SnO₄, and Zn₂SnO₄ with Sn, Sb, F, and Al. Incidentally, ZnO is preferable as a transparent conductive film material since it has high optical transparency, low resistance, and plasticity, and is inexpensive.

The photoelectric conversion layers 12 and 13 are formed in strips on the transparent conductive film 11. The photoelectric conversion layers 12 and 13 are each formed of an amorphous silicon semiconductor. The photoelectric conversion layers 12 and 13 according to this embodiment are formed of an amorphous silicon semiconductor and a microcrystalline silicon semiconductor, respectively. Incidentally, in this description, the term "microcrystalline" represents a state in which numbers of minute crystal grains are included, and also a state in which an amorphous state is partially included.

Here, the photoelectric conversion layer 12 according to this embodiment is formed by stacking in sequence a p-i-n amorphous silicon semiconductor, while the photoelectric conversion layer 13 is formed by stacking in sequence a p-i-n microcrystalline silicon semiconductor. A tandem solar cell module formed by using amorphous silicon and microcrystalline silicon in this manner has a structure in which two types of semiconductors having different light absorption wavelengths are stacked, and is capable of effectively using solar spectrum.

The back surface electrode 14 (second electrode) is formed in strips on the photoelectric conversion layers 12 and 13. The back surface electrode 14 is formed of a conductive member such as Ag.

The protecting member 16 is disposed on the bonding layer 15. The protecting member 16 is formed of a resin film such as PET, PEN, ETFE, PVDF, PCTFE, PVF, or PC. Alternatively, the protecting member 16 may have a structure or a single body in which glass or the like sandwiches a metal foil in between, or may be formed of a metal (a steel plate) such as SUS or Galvalume.

The protecting member 16 is bonded to the back surface of the bonding layer 15. The bonding layer 15 is formed of resin such as EVA, EEA, PVB, silicon, urethane, acrylic, or epoxy. The bonding layer 15 serves as an adhesive agent and a buffering agent between the protecting member 16 and the photovoltaic element.

In addition, the solar cell module according to this embodiment includes a first groove 22 that separates the photoelectric conversion layers 12 and 13 and the back surface electrode 14 on the transparent conductive film 11 at an end portion of the photovoltaic layer 1, which is parallel to a series connection direction of the photovoltaic layer 1.

The solar cell module further includes a stacked body 20 that is arranged on the transparent substrate 10 at the end portion of the bonding layer 15, which is parallel to a series connection direction of the photovoltaic layer 1. The stacked body 20 is electrically isolated from the photovoltaic layer 1, and formed by stacking in sequence the transparent conductive film 10, the photoelectric conversion layers 12 and 13, and the back surface electrode 14. That is, the stacked body 20 is disposed on upper and lower end portions of the solar cell sub-module shown in Fig. 3. Here, the stacked body 20 is an ineffective area not contributing to power generation, and may be formed by stacking at least the transparent conductive film 11, and the photoelectric conversion layers 12 and 13.

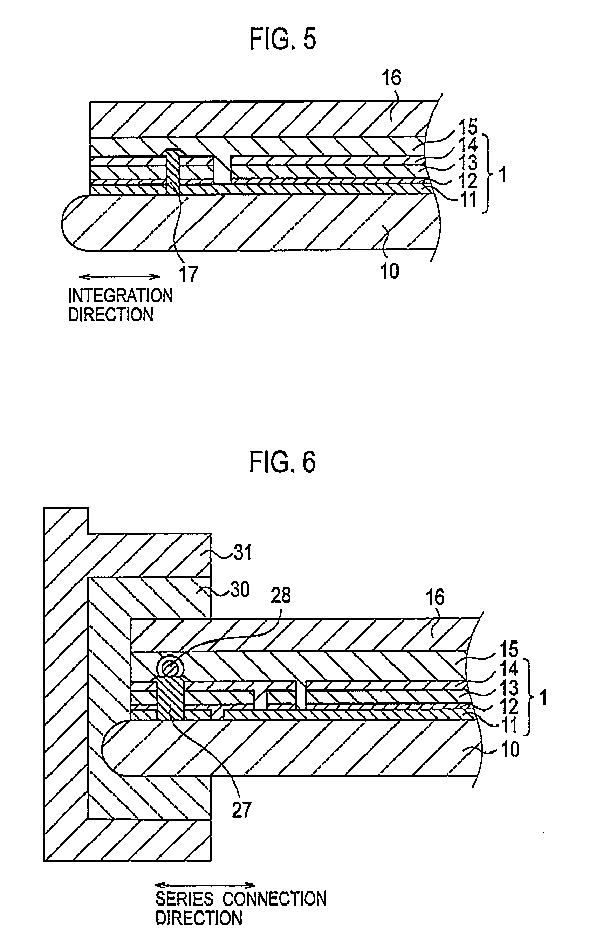

Further, the width of a second groove 21 separating the photovoltaic layer 1 from the stacked body is preferably equal to or more than 0.1 mm. Furthermore, the second groove 21 may be filled with an insulating film 17 as shown in Fig. 5. For the insulating film 17, any one of materials of oxide silicon, silicon nitride, aluminum oxide, titanium oxide, and magnesium fluoride, or a resin material including particles formed of at least any one of these materials may be used.

Note that, the second groove 21 prevents electric current from leaking between the photovoltaic elements due to a semiconductor layer which is formed by wrapping around a side of the photovoltaic layer 1 at the time of forming the photovoltaic layer 1.

Incidentally, Fig. 6 is the B-B cross-sectional view in an end portion parallel to an integration direction of the photovoltaic layer 1, i.e. left and right end portions of the solar cell sub-module shown in Fig. 3. In this manner, in the end portion parallel to the integration direction, a solder 27 connected to a lead wire 28 for taking out electric current is disposed over approximately the entire length of a side parallel to the integration direction. The taking out of electric current described above is established by causing the solder 27 to be short-circuited to the transparent conductive film 11 (first electrode). Further, a metal frame 31 such as aluminum is attached along the end portion parallel to the integration direction with resin 30 such as Butyl rubber.

### (Manufacturing Method of Solar Cell Module)

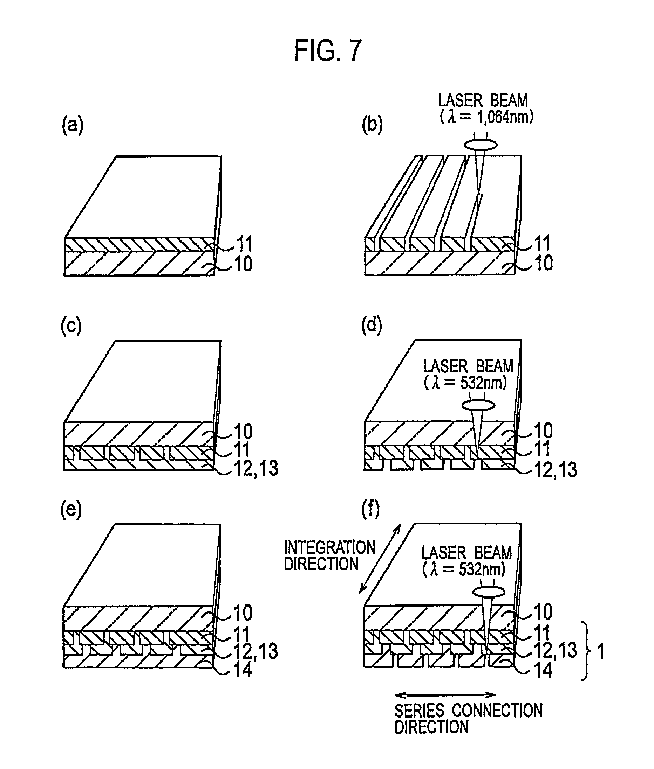

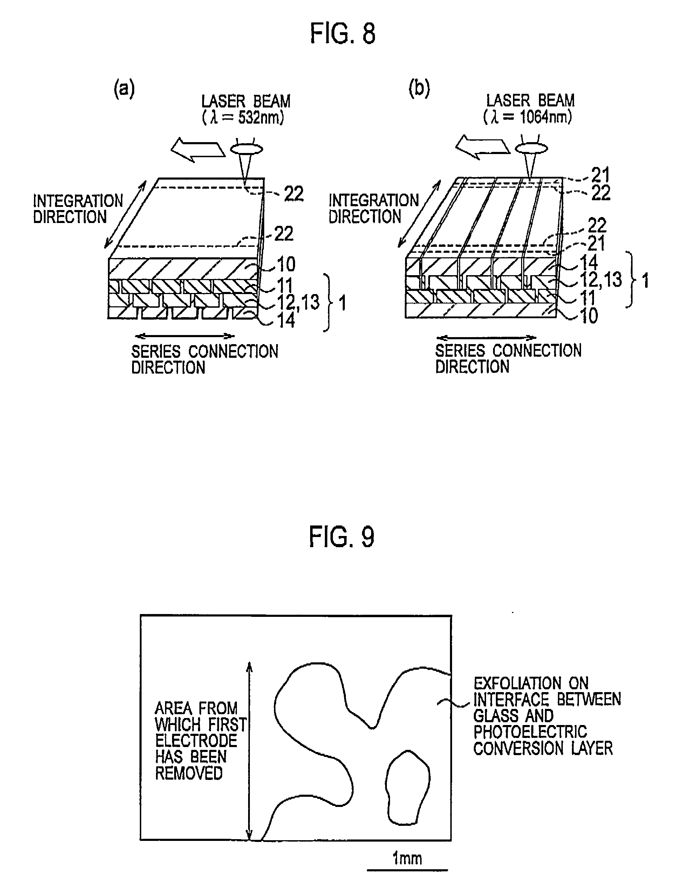

A manufacturing method of the thin-film solar cell module according to this embodiment will be described with reference to Figs. 7 and 8.

As shown in Fig. 7(a), the transparent conductive film 11 is formed on the transparent substrate 10 by sputtering. Then, as shown in Fig. 7(b), the transparent conductive film 11 is patterned in strips by YAG laser irradiation, and is electrically isolated between the photovoltaic elements.

Next, as shown in Fig. 7(c), by using a plasma CVD method, the photoelectric conversion layers 12 and 13 are formed. To be more precise, on the transparent conductive film 11, p-i-n amorphous silicon semiconductors are stacked in sequence so as to form the photoelectric conversion layer 12. Thereafter, on the photoelectric conversion layer 12 thus formed, p-i-n microcrystalline silicon semiconductors are stacked in sequence so as to form the photoelectric conversion layer 13. As shown in Fig. 7(d), the photoelectric conversion layers 12 and 13 are irradiated with YAG laser, on a position a predetermined distance away from each patterning position of the transparent conductive film 11, so that they can be patterned in strips.

Then, as shown in Fig. 7(e), the back surface electrode 14 is formed on the photoelectric conversion layer 13 by sputtering or the like. Subsequently, as shown in Fig. 7(f), the back surface electrode 14 is irradiated with YAG laser from a back surface side, on a position a predetermined distance away from each patterning position of the photoelectric conversion layers 12 and 13, so that it can be patterned in strips. Thereafter, dry etching is performed on a groove formed in the back surface electrode 14 up to a desired depth.

Subsequently, in this embodiment, YAG laser is applied to end portions of the solar cell module in a direction (series connection direction) perpendicular to a laser patterning direction (integration direction) in Fig. 7, as shown in Fig. 8(a). Then, the photoelectric conversion layers 12 and 13, and the back surface electrode 14 are simultaneously removed so as to form the first grooves 22.

Next, as shown in Fig. 7(b), the substrate is turned upside down, and YAG laser is applied on positions slightly outside the first groove 22, from the surface side of forming the solar cell element, in a direction perpendicular to the laser patterning direction shown in Fig. 7. Thereafter, the transparent conductive film 10, the photoelectric conversion layers 12 and 13, and the back surface electrode 14 are simultaneously removed so as to form the second grooves 21.

The orders of the process (Fig. 8(a)) of forming the first grooves 22 and the process (Fig. 8(b)) of forming the second grooves 21 may be reversed. That is, the first grooves 22 may be formed after the second grooves 21 are formed.

Next, although not illustrated in the drawing, an extracted electrode is attached with ultrasonic soldering and copper foil lead. Subsequently, the bonding layer 15 and the protecting member 16 are arranged in sequence on the photovoltaic element, and they are heated under vacuum and pressure bonded by using a laminating apparatus. Thereby, the back surface of the photovoltaic element is protected.

In the manner described above, the thin-film solar cell sub-module according to this embodiment as shown in Fig. 4 is formed. Further, a terminal box and the extracted electrode are connected to this solar cell sub-module, and the metal frame formed of aluminum or the like is attached thereon with resin such as Butyl rubber, so that the solar cell module can be formed.

### (Advantages and effects)

As shown in Fig. 4, the solar cell module of this embodiment includes the first groove 22 that separates the photoelectric conversion layers 12 and 13 and the back surface electrode 14 on the transparent conductive film 11 at the end portion of the photovoltaic layer 1 parallel to the series connection direction of the photovoltaic layer 1,. In this manner, since there is no interface between the transparent substrate 10 and the photoelectric conversion layers 12 and 13, it is possible to suppress exfoliation of the film due to internal stress by the photoelectric conversion layers 12 and 13. Particularly, in the thin-film silicon solar-cell module in which microcrystalline silicon (µc-Si:H) is used for the photoelectric conversion layers 12 and 13, internal stress of µc-Si:H is quite large compared with those of other electrode film and amorphous silicon (a-Si:H). In the solar cell module according to this embodiment, since there is no interface between the transparent substrate 10, which has the smallest bonding force, and the photoelectric conversion layers 12 and 13, it is possible to suppress the exfoliation of the film.

In addition, since the stacked body 20 is disposed at the end portion of the bonding layer 15, which is parallel to the series connection direction of the photovoltaic layer 1, there is no bonding surface between the end portions of the bonding layer 15 and the transparent substrate 10. Therefore, it is possible to prevent moisture from penetrating from the end portions of the bonding layer 15 through the bonding surface between the bonding layer 15 and the transparent substrate 10.

Additionally, when pressure is applied, the second groove 21 separating the photovoltaic layer 1 and the stacked body 20 is capable of preventing electric current from leaking from the back surface electrode 14 to the transparent conductive film 11. For this reason, it is preferable that the width of the second groove 21 be 0.1 mm or more.

Further, in this embodiment, as shown in Fig. 5, the second groove 21 may be filled with the insulating film 17. In accordance with this solar cell module, provision of the insulating film 17 enables the enhancement of the insulating property and strength against destruction.

Furthermore, in the solar cell module according to this embodiment, as shown in Fig. 6, in the end portion parallel to the integration direction of the photovoltaic layer 1, the solder 27 is disposed over approximately the entire length of the side. The solder 27 prevents moisture from penetrating to a power generation area (effective area). The taking out of electric current is established by causing the solder 27 to be short-circuited to the transparent conductive film 11. Thus, no problem occurs due to the occurrence of short-circuit which is caused by moisture penetrating through the end portion parallel to the integration direction. Thus, in this embodiment, various contrivances have been made to the end portions parallel to the series connection direction of the photovoltaic layer 1.

### (Other Embodiments)

The present invention has been described by using the above embodiment. However, it should not be understood that the descriptions and drawings constituting a part of this disclosure will limit the present invention. Various alternative embodiments, examples, and operational techniques will be apparent to those skilled in the art from this disclosure.

For example, in the above embodiment, the photoelectric conversion layers 12 and 13 formed by stacking in sequence an amorphous silicon semiconductor and a microcrystalline silicon semiconductor are used. However, the same effect can be achieved by using a stacked body formed of a single layer of the microcrystalline silicon semiconductor or the amorphous silicon semiconductor, or more than two layers of the microcrystalline silicon semiconductor and the amorphous silicon semiconductor.

As has been described, it is needless to say that the present invention includes various embodiments and the like that are not described herein. Accordingly, the technical scope of the present invention is defined only by the inventive specified matters according to the scope of claims which are appropriate from the above descriptions.

### EXAMPLES

The thin-film solar cell module according to the present invention will be more specifically described below with reference to the following example. However, the present invention is not limited to the following example, and various modifications can be made as needed without deviating from the gist thereof.

### (Example 1)

As a thin-film solar cell module according to Example 1 of the present invention, a solar cell module shown in Fig. 4 was manufactured as follows.

As shown in Fig. 7(a), on a glass substrate 10 having a thickness of 4 mm, a ZnO electrode 11 having a thickness of 600 nm was formed by sputtering. Thereafter, as shown in Fig. 7(b), the ZnO electrode 11 was irradiated with YAG laser from the light incident side of the glass substrate 10 so that the ZnO electrode 11 would be patterned in strips in the integration direction. In the laser isolation processing, used was Nd:YAG laser having a wavelength of about 1.06 µm, an energy density of 13 J/cm³, and a pulse frequency of 3 kHz.

Next, as shown in Fig. 7(c), by using a plasma CVD method, an amorphous silicon semiconductor layer 12 and a microcrystalline silicon semiconductor layer 13 were formed. To be more precise, by using a plasma CVD method, first, a p-type amorphous silicon semiconductor layer having a film thickness of 10 nm was formed by mixed gas of SiH₄, CH₄, H₂, and B₂H₆. Thereafter, on the p-type amorphous silicon semiconductor layer, an i-type amorphous silicon semiconductor layer having a film thickness of 300 nm was formed by mixed gas of SiH₄ and H₂. Subsequently, on the i-type amorphous silicon semiconductor layer, an n-type amorphous silicon semiconductor layer having a film thickness of 20 nm was formed by mixed gas of SiH₄, H₂, and PH₃. In this fashion, the amorphous silicon semiconductor layer 12 was formed. Subsequently, by using a plasma CVD method, on the amorphous silicon semiconductor layer 12, a p-type microcrystalline silicon semiconductor layer having a film thickness of 10 nm was formed by mixed gas of SiH₄, H₂, and B₂H₆. Thereafter, on the p-type microcrystalline silicon semiconductor layer, an i-type microcrystalline silicon semiconductor layer having a film thickness of 2000 nm was formed by mixed gas of SiH₄ and H₂. Subsequently, an n-type microcrystalline silicon semiconductor layer having a film thickness of 20 nm was formed by mixed gas of SiH₄, H₂, and PH₃. Thus, the microcrystalline silicon semiconductor layer 13 was formed. Conditions of the plasma CVD method are shown in detail in Table 1.

**[Table 1]**

| Table of plasma CVD conditions | | | | | | |
|---|---|---|---|---|---|---|
| | Layer | Substrate temperature (degree C) | Gas flow (sccm) | Reaction pressure (Pa) | RF power (W) | Film pressure (nm) |
| a-Si film | p layer | 180 | SiH₄:300 | 106 | 10 | 10 |
| | | | CH₄:300 | | | |
| | | | H₂:2000 | | | |
| | | | B₂H₆:3 | | | |
| | i layer | 200 | SiH₄:300 | 106 | 20 | 300 |
| | | | H₂:2000 | | | |
| | n layer | 180 | SiH₄:300 | 133 | 20 | 20 |
| | | | H₂:2000 | | | |
| | | | PH₃:5 | | | |
| Microcrystalline Si film | p layer | 180 | SiH₄:10 | 106 | 10 | 10 |
| | | | H₂:2000 | | | |
| | | | B₂H₆:3 | | | |
| | i layer | 200 | SiH₄:100 | 133 | 20 | 2000 |
| | | | H₂:2000 | | | |
| | n layer | 200 | SiH₄:10 | 133 | 20 | 20 |
| | | | H₂:2000 | | | |
| | | | PH₃:5 | | | |

Further, as shown in Fig. 7(d), the amorphous silicon semiconductor layer 12 and the microcrystalline silicon semiconductor layer 13 were irradiated, with YAG laser, from the light incident side on a position lateral to the patterning position of the ZnO electrode 11 by 50 µm so that the amorphous silicon semiconductor layer 12 and the microcrystalline silicon semiconductor layer 13 would be patterned in strips. In the laser isolation processing, used was Nd:YAG laser having an energy density of 0.7 J/cm³ and a pulse frequency of 3 kHz.

Next, as shown in Fig. 7(e), an Ag electrode 14 having a thickness of 200 nm was formed on the microcrystalline silicon semiconductor layer 13 by sputtering. Further, the amorphous silicon semiconductor layer 12, the microcrystalline silicon semiconductor layer 13, and the Ag electrode 14 were irradiated from the back surface side with YAG laser so as to be patterned in strips. In the laser isolation processing, used was Nd:YAG laser having an energy density of 0.7 J/cm³ and a pulse frequency of 4 kHz. Further, dry etching by using CF₄ was performed for several tens of seconds.

Next, as shown in Fig. 8(a), a second high frequency wave (wavelength: 532 nm) of Nd:YAG laser was applied to the end portions of the solar cell module in the direction (series connection direction) perpendicular to the laser patterning direction in Fig. 6. Thereafter, the amorphous silicon semiconductor layer 12, the microcrystalline silicon semiconductor layer 13, and the Ag electrode 14 were simultaneously removed so as to form the first groove 22. The width of the first groove 22 was 100 µm.

Next, as shown in Fig. 8(b), the substrate was turned upside down, and a fundamental wave (wavelength: 1064 nm) of Nd:YAG laser was applied on a position slightly outside the first groove 22 from the surface (back surface side) side of forming the solar cell element, in the direction (series connection direction) perpendicular to the laser patterning direction in Fig. 7. Thereafter, the ZnO electrode 10, the amorphous silicon semiconductor layer 12, the microcrystalline silicon semiconductor layer 13, and the Ag electrode 14 were simultaneously removed so as to form the second groove 21. The width of the second groove21 was 1.0 mm.

Here, the practical processing width of the fundamental wave of Nd:YAG laser forming the second groove 21 was approximately 0.01 mm at minimum. For this reason, scanning operation was performed 100 times to acquire a width of 1.0 mm required as a groove opening width for satisfying an insulation test condition (one-minute application of DC 1000V+(2×Release voltage of photovoltaic system)) of IEC 61646 being a product standard required for a solar cell module.

Next, an extracted electrode was attached with ultrasonic soldering and copper foil lead.

Subsequently, a stacked body formed by arranging in sequence an EVA 15 and a PET film 16 on the photovoltaic element was subjected to heat treatment at 150 degrees C for 30 minutes using a laminating apparatus. Thereby, the EVA 16 was bridged and stabilized, and the stacked body was thus press bonded under vacuum.

Last, a terminal box was attached, and the extracted electrode was connected. Thereby, the thin-film solar cell modules 10 according to one example of the present invention was completed.

### (Example 2)

As Example 2 of the present invention, a solar cell module shown in Fig. 5 was made. Processing for Example 2 was the same as that for Example 1, except that the second groove 21 was filled with an insulating film 17.

In addition, the insulating film 17 was formed by applying epoxy resin including aluminum oxide (Al₂O₃) particles.

### (Conventional Example 1)

As Conventional Example 1, a solar cell module shown in Fig. 1 was made. Processing for Conventional Example 1 was the same as that for Example 1, except that YAG laser patterning was different from that of Example 1. However, as shown in Fig. 1, there is no photoelectric conversion element in end portions of the solar cell module. That is, in the end portions, there is an interface between a glass substrate 110 and an EVA 115. Further, there is an interface between the glass substrate 110 and an amorphous silicon semiconductor layer 12.

### (Conventional Example 2)

As Conventional Example 2, a solar cell module shown in Fig. 2 was made. Processing for Conventional Example 2 was the same as that for Example 1, except that YAG laser patterning was different from that of Example 1. However, as shown in Fig. 2, there is no photoelectric conversion element in end portions of the solar cell module. That is, in the end portions, there is an interface between a glass substrate 110 and an EVA 115. Further, there is an interface between the glass substrate 110 and an amorphous silicon semiconductor layer 12.

### (Reliability Evaluation)

In order to compare the reliabilities of the thin-film solar cell modules according to this example, and those of the thin-film solar cell modules according to the conventional example, weather resistance reliability evaluation was carried out. To be more specific, in accordance with IEC 61646, each module was exposed for 1000 hours under the circumstances of a temperature of 85 degrees C and a humidity of 85%.

### (Result)

In both of Conventional Examples 1 and 2, as shown in Fig. 9, exfoliation has occurred, within 100 hours, on an interface between the glass substrate 110 and the amorphous silicon semiconductor layer 12. In Fig. 9, in an area in which the transparent conductive film 111 (first electrode) was removed, the exfoliation has occurred on the interface between the glass substrate 110 and the amorphous silicon semiconductor layer 112.

Meanwhile, in both of Examples 1 and 2, even after 1000 hours have passed, no exfoliation has occurred. Therefore, it was found out that by having a structure including the first groove 22, no interface exists between the glass substrate 10 and the amorphous silicon semiconductor layer 12, so that exfoliation of the film was able to be prevented. It was also found out that by disposing the stacked body 20 in the end portions in the series connection direction of the photovoltaic layer, moisture was able to be prevented from penetrating from the end portions through the bonding surface between the EVA 15 and the glass substrate 10.

Particularly, in Example 2, it was found out that compared to thermosetting resin to be used as a bonding layer of the second groove 21, a material having a high dielectric breakdown strength was embedded in the second groove 21, so that a sufficient strength was maintained even if the width of the opening of the second groove 21 was set to 0.1 mm.

Note that, the entire contents of Japanese Patent Application No. 2006-265868 (filed on September 28, 2006) are herein incorporated by reference.

### INDUSTRIAL APPLICABILITY

As has been described above, the thin-film solar cell module according to the present invention is capable of achieving low cost and high efficiency of solar cells by suppressing exfoliation of a film, so that it is useful for solar power generation.

## Claims

1. A solar cell module in which a photovoltaic layer and a bonding layer are disposed in sequence on a transparent substrate, the photovoltaic layer formed by connecting in series a plurality of photovoltaic elements each formed by stacking in sequence a first electrode, a photoelectric conversion layer, and a second electrode, the solar cell module comprising:
a groove configured to separate both of the photoelectric conversion layer and the second electrode on the first electrode at an end portion of the photovoltaic layer parallel to a series connection direction of the photovoltaic layer.

2. The solar cell module according to claim 1, further comprising:
a stacked body formed by stacking in sequence the first electrode and the photoelectric conversion layer on the transparent substrate at an end portion of the bonding layer parallel to the series connection direction of the photovoltaic layer, the stacked body is arranged to be electrically isolated from the photovoltaic layer.

3. The solar cell module according to claim 2, wherein a width of a groove separating the photovoltaic layer from the stacked body is equal to or more than 0.1 mm.

4. The solar cell module according to any one of claims 2 and 3, wherein an insulating film is embedded in the groove separating the photovoltaic layer and the stacked body.

5. The solar cell module according to claim 4, wherein the insulating film is any one of materials of silicon oxide, silicon nitride, aluminum oxide, titanium oxide, and magnesium fluoride, or a resin material including particles of at least one of these materials.
